# EUROPEAN PATENT SPECIFICATION

(11) **EP 2 559 070 B1**
(45) Date of publication and mention of the grant of the patent: **07.10.2015**
(21) Application number: 11724445.9
(22) Date of filing: 12.04.2011
(51) Int. Cl.: H01L 31/048, H01L 31/054

(54) **METHOD FOR MANUFACTURING A PHOTOVOLTAIC CELL FOR INTEGRATED BUILDING APPLICATIONS**
VERFAHREN ZUR HERSTELLUNG EINER PV-ZELLE FÜR INTEGRIERTE GEBÄUDEANWENDUNGEN
PROCÉDÉ DE FABRICATION D'UNE CELLULE PHOTOVOLTAÏQUE POUR DES APPLICATIONS INTÉGRÉES À DES BÂTIMENTS

(30) Priority: 12.04.2010 IT MI20100614
(43) Date of publication of application: 20.02.2013
(73) Proprietor: Industria E Innovazione S.p.A., Milano (IT); Politecnico Di Milano, Milano (IT)
(72) Inventor: CAPORALE, Federico, I-00198 Roma (IT); DI FONZO, Fabio, I-20136 Milano (IT); DI STANISLAO, Marco, I-20033 Desio (IT); MASI, Maurizio, I-20124 Milano (IT); TONINI, Maura, I-30164 Mestre (IT)
(74) Representative: Bergadano, Mirko
(86) International application number: PCT/IB2011/000807
(87) International publication number: WO 2011/128757

(56) References cited:
- WO-A1-2008/153623
- GB-A- 2 188 924
- JP-A- 2000 208 788
- JP-A- 2009 064 981
- US-A1- 2003 070 706
- US-A1- 2008 115 828
- US-A1- 2008 160 275
- US-B2- 7 368 655
- ESCARRE J ET AL: "Hot Embossing of Polymer Substrates for Thin Silicon Cell Applications", PHOTOVOLTAIC ENERGY CONVERSION, CONFERENCE RECORD OF THE 2006 IEEE 4TH WORLD CONFERENCE ON, IEEE, PI, 1 May 2006 (2006-05-01), pages 1556-1559, XP031007618, ISBN: 978-1-4244-0016-4

## Description

### TECHNICAL FIELD

The present invention relates to a photovoltaic cell, in particular for integrated building applications, and a method for manufacturing this cell.

The cell of the invention is particularly indicated for being used as a building element for making building structures, especially for making vertical walls.

### BACKGROUND ART

A field of application of great interest for photovoltaic cells and panels is that of so-called Building Integrated Photovoltaics (BIPV); in these applications, the photovoltaic panels are destined to substitute traditional building elements such as roofs, facades and so forth, with an evident synergetic effect and considerable savings from the building construction standpoint. However, two different problems limit the diffusion of these solutions: low energy efficiency and a generally unsatisfying aesthetic effect.

Low efficiency particularly afflicts photovoltaic panels installed on vertical walls, due to the significant loss of reflection caused by unfavourable orientation with respect to the sun. Solutions exist in which traditional panels are mounted at an optimal angle, but are limited to shadings and can in no way substitute building sheathing.

Given the architectural context, it becomes evident that the aesthetic rendering of a BIPV facade is of fundamental importance. The solutions currently available on the market are basically limited to three types of solar panels: single-crystal silicon, polycrystalline silicon and amorphous silicon. Of these, only the latter can be made in a uniform and semitransparent manner on large surfaces, and so might find an application in architecture; in any case, the choice' of colours with these products remains very limited.

The above-mentioned problems are not fully solved by a solar cell according to JP2009064981, which discloses a solar cell module having a transparent member which consists of a glass having surface projections. The projections are made by means of engraving rollers.

In conclusion, there is not a photovoltaic cell or panel available at the moment that can be used in architecture, especially for vertical surfaces, and which at the same time is adequately efficient from the energy standpoint and satisfactory from the aesthetic-architectural viewpoint (as well as being manufacturable with relatively moderate costs).

### DISCLOSURE OF INVENTION

One object of the present invention is therefore that of providing a photovoltaic cell that is devoid of the drawbacks of the known art pointed out herein; in particular, an object of the invention is that of providing a photovoltaic cell that can be used in integrated building applications, especially for making vertical walls for buildings and other architectural structures, while being relatively inexpensive and simple to make, efficient from the energy standpoint and with a satisfactory aesthetic appearance.

The present invention is therefore relative to a method for manufacturing photovoltaic cells as defined in claim 1.

The present invention actually provides a new support element for making various types of photovoltaic cells with a multilayer structure, for example, various types of thin film cells and photoelectrochemical cells or Graetzel cells; the support element is composed of a tile made of glass, in particular of moulded glass (i.e. obtained via a molten glass moulding operation), having opportunely shaped surfaces for confining sunlight inside the tile.

Various multilayer structures can be applied to the support element to form different types of photovoltaic cells, in particular thin film cells (for example, a-Si:H, micromorph silicon, Cd-Te, CIS/CIGS, and so on) and photoelectrochemical cells (so-called DSSC, "Dye Sensitized Solar Cells", or Graetzel cells).

As is known, unlike polycrystalline or single-crystal silicon cells, these cells are made by the successive depositing of various functional layers.

The cells in accordance with the invention differ with respect to some known solutions (in which a separately made optical element is mounted on an ordinary cell to function as a lens to focus rays on the active element) due to the fact that the active structure of the cell is constructed directly on the already opportunely shaped substrate (tile).

In accordance with the invention, both the support element and the photovoltaic cell as a whole are relatively simple and economical to manufacture.

Thanks to the particular structure and geometry of the support element, the photovoltaic cell of the invention, however made, can be used as a building element with high efficiency, even and especially for making vertical walls; the cell of the invention can also be made in various shapes, sizes and colours, so as to create walls having different aesthetic-architectural effects.

### BRIEF DESCRIPTION OF THE DRAWINGS

Further characteristics and advantages of the present invention shall become apparent from the description of the following non-limitative embodiments, with reference to the attached drawings, where:
- Figure 1 is an schematic view, in longitudinal section and out of scale, of a portion of a photovoltaic cell in accordance with a first embodiment of the invention, and
- Figure 2 is a schematic view, in longitudinal section and out of scale, of a portion of a photovoltaic cell in accordance with a second embodiment of the invention.

### BEST MODE FOR CARRRYING OUT THE INVENTION

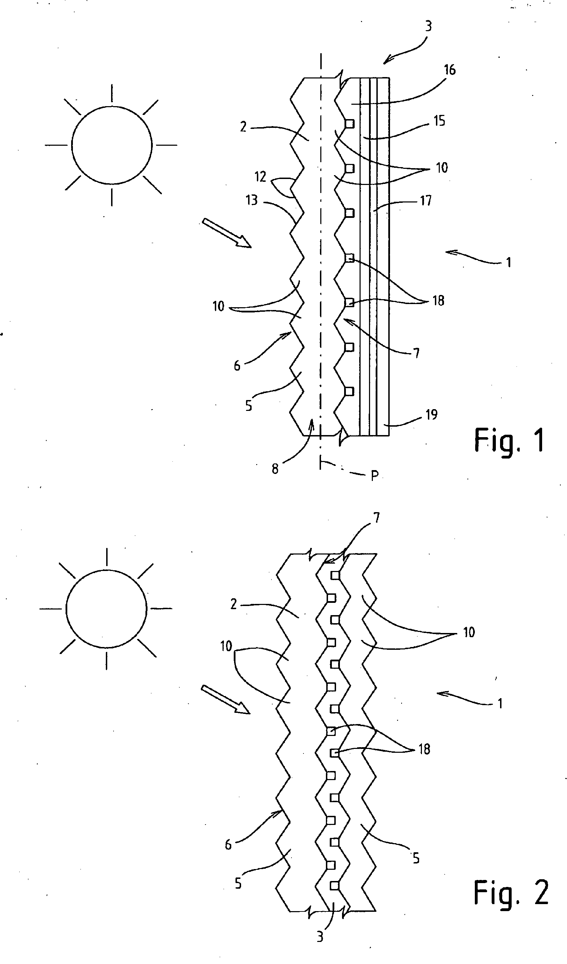

In Figure 1, a photovoltaic cell, in particular a multilayer thin film cell, is indicated as a whole by reference numeral 1.

The cell 1 comprises a support element 2 and a multilayer active structure 3, carried by the support element 2 and formed by a plurality of functional layers that, as a whole, are able to convert light energy into electrical energy via the photovoltaic effect.

The support element 2 consists of a tile 5 made of glass and that is basically prismatic, for example having a quadrangular (rectangular or square) plan shape; the tile 5 has two larger opposite faces 6, 7, arranged on opposite sides of a central plane P, and a perimeter edge 8 that connects the two faces 6, 7.

In use, the face 6 is destined to face directly to the sun and therefore constitutes an outer face of the tile 5; the other face 7 constitutes an inner face of the tile 5.

The tile 5 is advantageously composed of a monolithic piece made of moulded glass, i.e. obtained by the pressure moulding of molten glass.

Here and hereafter, the following meanings are intended:
- "pressure moulding of molten glass" is a mechanical process of plastic deformation carried out by hot dynamic action exerted by a press on molten glass in order to make the glass fill a cavity between two metal dies; in pressure moulding, an opportune quantity of molten glass having suitable temperature and plasticity characteristics is introduced into a hot metal die, into which a counter die is then immersed that, by exerting pressure, forces the glass to occupy the space between the die and the counter die, thereby determining the thickness and shape of the object to be made,
- a tile or piece made "of moulded glass" is a manufactured item made by a pressure moulding operation on molten glass.

The two faces 6, 7 have opportunely shaped surfaces for confining sunlight inside the tile 5; in particular, the faces 6, 7 are shaped to confine and trap the light incident on the outer face 6 inside the tile 5 and avoid or limit light leaving through the faces 6, 7, giving rise to multiple total reflections.

In other terms, the faces 6, 7 are shaped such that the active structure 3 has high conversion efficiency in the conditions of use of the cell 1 and therefore, in particular, when the support element 2 and therefore the cell 1 as a whole are arranged vertically (plane P vertical, such as on a vertical wall of a building for example).

In fact, in accordance with a preferred embodiment of the invention, the cell 1 is destined to form a building panel for making building structures, in particular for making vertical walls; in this preferred application, the cell 1 is therefore installed substantially vertically, that is to say with plane P substantially vertically, and the faces 6, 7 are shaped in consequence.

In particular, the faces 6, 7 have respective series of projections 10 defining light orientation patterns.

The projections 10 and the patterns they define are shaped such that, in use, sunlight incident on the outer face 6 is confined inside the tile 5 and, consequently, such that the energy conversion efficiency of the cell 1 is optimized.

In particular, the outer face 6 is shaped so as give the active structure 3 an optimal orientation with respect to the sun, also according to the place of installation; the projections 10 of the outer face 6 are therefore also designed, if necessary, according to the latitude or, in any case, the location where the cell 1 will be installed.

In particular, each face 6, 7 has a crested surface and shows a succession of crests and grooves.

Preferably, each face 6, 7 has a substantially saw-toothed lateral profile.

The projections 10 are ridges that extend longitudinally along their respective axes; in particular, the projections 10 are essentially prismatic ridges and extend along respective straight axes that are parallel to each other and to the central plane P and, in use, are substantially horizontal.

The projections 10 of each face 6, 7 are arranged parallel to each other with a set pitch that is preferably constant.

Each projection 10 has a pair of lateral sides 12 converging to a free extremity 13 or apex that, preferably, consists of an edge.

In the example shown in Figure 1, the projections 10 are substantially V-shaped and have a substantially triangular cross-section.

The production method chosen for making the tile 5 enables recurring profiles composed of elements even of quite complex geometry, such as a scalene triangle for example, to be obtained. In consequence, the geometry of the projections 10 can easily be adapted to the specific latitude where it is planned to use the cell 1.

The patterns formed by the projections 10 on the faces 6, 7 can be the same, similar or different, as they are formed by projections 10 that have the same or different shapes, sizes and/or layout on the two faces 6, 7.

For example, the projections 10 of the inner face 7 can be arranged with the same or a different pitch, in particular a lower one, with respect to the projections 10 of the outer face 6; advantageously, the projections 10 of the inner face 7 are offset with respect to the projections 10 of the outer face 6, as shown in Figure 1, for the purpose of optimizing light entrapment inside the tile 5 through multiple total reflections.

Advantageously, but not necessarily, the inner face 7 is microstructured, i.e. it has uniformly distributed incisions of micrometric dimensions (less than a millimetre), in order to diffuse light inside tile 5 and therefore onto the active structure 3.

The support element 2 constitutes a substrate on which the active structure 3 is arranged, which is specifically arranged on the inner face 7 of the tile 5, namely on the opposite face to the face that is destined, in use, to face the sun.

The active structure 3 can be of any known type, for example, a multilayer thin film structure.

In general, the active structure 3 includes at least one active layer 15 for the conversion of light rays into electrical current (i.e. possessing the photovoltaic effect), arranged between a front conductive layer 16, made of transparent conductive oxide for example, and a back conductive layer 17, made of a metallic material or transparent conductive oxide for example; the conductive layers 16 and 17 are arranged on opposite sides of the active layer 15 and, optionally, the active structure 3 can include one or more barrier layers.

In the preferred embodiment shown in Figure 1, a plurality of longitudinally elongated conductive elements 18 are positioned along respective projections 10 of the inner face 7 and precisely on the free extremities 13 (apexes or edges) of these projections. These conductive elements 18 serve to collect the charge generated by the active structure 3. The conductive elements 18 are advantageously embedded in the front conductive layer 16 and completely buried therein, on the side facing the tile 5.

However, it is understood that, depending on the applications, the conductive elements 18 can be arranged in other positions, for example, on tips, depressions or even on the lateral surfaces of the profile not directly exposed to the sun.

At the back (i.e. on the side opposite to the support element 2), the active structure 3 can be closed/sealed by an opportune coating 19 formed, for example, by a metalized layer and/or a polymeric layer.

The cell 1 is made by a manufacturing process that basically comprises the steps of:
- moulding the tile 5 by the moulding of molten glass, and
- depositing the active structure 3 on face 7 of the tile.

As previously pointed out, the tile 5 is made through the pressure moulding of molten glass, namely by hot plastic deformation exerted by a press on a mass of molten glass in a mould; the molten glass is introduced into a cavity between two dies (die and counter die) that define the shape of the tile to be made.

The faces 6, 7 are made in the desired shape (hence provided with projections 10) directly in the moulding step. A die having two opposite moulding faces shaped to make the respective faces 6, 7 is used; the moulding surface that forms the inner face 7 may possibly be embossed or machined to create the microstructured surface of the face 7.

In turn, the depositing step of the active structure 3 includes, for example, the steps of:
- applying the contact elements 18 on the projections 10 of face 7,
- depositing the front conductive layer 16 so as to embed the contact elements 18, and
- depositing the other layers of the active structure 3 in succession, for example, the active layer 15 and the back conductive layer 17.

Lastly, and optionally, the coating 19 for covering the active structure 3 on the side opposite to the support element 2 is applied.

In the embodiment in Figure 2, in which details that are the same or similar to those already described are indicated with the same reference numerals, the cell 1 comprises two tiles 5 coupled to each other and an active structure 3 inserted between the two tiles 5.

Each tile 5 is advantageously provided with a plurality of contact elements 18, arranged on the projections 10 of the inner faces 7 of both tiles 5 and buried in respective conductive layers. One or more active layers and possibly other functional layers, for example barrier layers to form the active structure 3, are included between the conductive layers.

The perimeter edges 8 of the tiles 5 are shaped so as to realize a shape coupling or geometric coupling or a mechanical joint.
The perimeter edges 8 of the two tiles 5 are then advantageously joined to each other and sealed, by heat treatment for example, in order to seal the active structure 3 inside them. This processing enables hermetic and almost everlasting sealing of the cell 1 to be achieved. This solution is particularly indicated in the case of photoelectrochemical cells (Graetzel cells or dye-sensitized solar cells, DSSC), as the sealing avoids the problem once and for all of electrolyte leakage from the inside of the cell and consequent rapid deterioration.

In this case, the active structure 3 includes (as in a typical Graetzel cell) two electrodes separated by a matrix, in titanium dioxide for example, which contains a liquid active substance (typically a colouring agent) and an electrolytic solution.

## Claims

1. A method for manufacturing a photovoltaic cell (1), in particular for building integrated photovoltaic applications, comprising the steps of:
- moulding a tile (5) of glass by pressure moulding of molten glass, providing directly in the moulding step a first face (6) and a second face (7), opposite to the first face (6), of the tile (5), and providing both of said opposite faces (6, 7) with respective series of projections (10) defining light orientation patterns for confining the light incident on a first face (6) inside the tile (5) and avoiding or limiting light leaving through the faces (6, 7), due to multiple total reflections; the projections (10) being essentially prismatic ridges and extending longitudinally along respective straight axes that are parallel to each other and to a central plane (P) of the tile (5) and, in use, are substantially horizontal; the projections (10) of each face (6, 7) being arranged parallel to each other with a set pitch; each projection (10) having a pair of lateral sides (12) converging to a free extremity (13) or apex that consists of an edge; the projections (10) being V-shaped and having a substantially triangular cross-section; the tile (5) being a monolithic piece made of moulded glass obtained by pressure moulding of molten glass in a mould having two opposite moulding faces shaped to make said faces (6, 7) respectively, both the faces (6, 7) being made in the desired shape and provided with said projections (10) directly in the moulding step, a mould having two opposite moulding faces shaped to make the respective faces (6, 7) being used; and
- depositing on said second face (7) of the tile (5), opposite to the first face (6), an active structure (3) capable of converting light energy into electrical energy by photovoltaic effect.

2. The method according to claim 1, wherein the moulding surface that forms the inner face (7) are embossed or machined to create a microstructured surface of the face (7).

3. The method according to one of the preceding claims, wherein the depositing step of the active structure (3) includes the steps of: applying a plurality of longitudinally elongated conductive elements (18) along respective projections (10) of the second face (7); depositing a front conductive layer (16) so as to embed and completely bury the contact elements (18) therein, on the side opposite to the tile (5); depositing other layers of the active structure (3) in succession, for example, an active layer (15) and a back conductive layer (17).

4. The method according to one of the preceding claims, comprising a step of covering the active structure (3), on the side opposite to the support element (2), with a coating (19), for example formed by a metalized layer and/or a polymeric layer.

5. The method according to one of the preceding claims, comprising a step of repeating the method according to any of claims 1 to 4 to produce a second tile; and a step of coupling the two tiles (5) to each other, said tiles (5) having respective faces (7) facing each other, with the active structure (3) interposed between the two tiles (5).

6. The method according to claim 5, wherein the two tiles (5) have respective perimeter edges (8) shaped so as to realize a shape coupling or geometric coupling or a mechanical joint.

7. The method according to claim 6, wherein the perimeter edges (8) of the two tiles (5) are joined to one another and sealed, in order to seal the active structure (3) inside them.

## Patentansprüche

1. Verfahren zum Herstellen eines Fotoelements (1), insbesondere für gebäudeintegrierte Fotovoltaikanwendungen, umfassend die Schritte:
- Formen einer Platte (5) aus Glas durch Druckformung von geschmolzenem Glas, indem bei dem Formungsschritt eine erste Oberfläche (6) und eine zweite Oberfläche (7) gegenüber der ersten Oberfläche (6) der Platte (5) direkt bereitgestellt werden und beide der genannten gegenüberliegenden Oberflächen (6, 7) mit jeweiligen Reihen von Vorsprüngen (10) versehen werden, die Lichtausrichtungsmuster zum Einschränken des auf eine erste Oberfläche (6) innerhalb der Platte (5) einfallenden Lichts und zum Vermeiden oder Begrenzen des durch die Oberflächen (6, 7) austretenden Lichts infolge von mehrfachen Totalreflexionen festlegen,
wobei die Vorsprünge (10) im Wesentlichen prismatische Erhöhungen sind und sich längs über jeweilige gerade Achsen erstrecken, die parallel zueinander und zu einer zentralen Ebene (P) der Platte (5) und im Gebrauch im Wesentlich horizontal verlaufen,
wobei die Vorsprünge (10) jeder Oberfläche (6, 7) mit einer festgelegten Teilung parallel zueinander angeordnet sind,
wobei jeder Vorsprung (10) ein Paar von Querseiten (12) aufweist, die zu einem freien Endpunkt (13) oder einer Spitze konvergieren, der bzw. die aus einer Kante besteht,
wobei die Vorsprünge (10) V-förmig sind und einen im Wesentlichen dreieckförmigen Querschnitt aufweisen,
wobei die Platte (5) ein monolithisches Stück ist, welches aus geformtem Glas besteht, das durch Druckformung von geschmolzenem Glas in einer Form erhalten wird, die zwei gegenüberliegende Formungsflächen aufweist, welche geformt sind, um die jeweiligen Oberflächen (6, 7) zu bilden,
wobei die beiden Oberflächen (6, 7) in der gewünschten Form gebildet und mit den Vorsprüngen (10) direkt bei dem Formungsschritt bereitgestellt werden, wobei eine Form zwei gegenüberliegende Formungsflächen aufweist, die geformt sind, um die jeweiligen benutzten Oberflächen (6, 7) zu bilden,
- und Niederschlagen einer aktiven Struktur (3), die imstande ist, Lichtenergie durch den fotovoltaischen Effekt in elektrische Energie umzusetzen, auf der zweiten Oberfläche (7) der Platte (5) gegenüber der ersten Oberfläche (6).

2. Verfahren nach Anspruch 1, wobei die Formungsfläche, welche die innere Oberfläche (7) formt, erhaben oder maschinell bearbeitet ist, um eine mikrostrukturierte Fläche der Oberfläche (7) zu erzeugen.

3. Verfahren nach einem der vorhergehenden Ansprüche, wobei der Schritt des Niederschlagens der aktiven Struktur (3) die Schritte umfasst:
- Aufbringen einer Vielzahl von längs gestreckten leitenden Elementen (18) längs jeweiliger Vorsprünge (10) der zweiten Oberfläche (7),
- Niederschlagen einer vorderen leitenden Schicht (16) auf der Seite gegenüber der Platte (5), derart, um die Kontaktelemente (18) darin einzubetten und vollständig einzugraben,
- Nacheinander erfolgendes Niederschlagen von weiteren Schichten der aktiven Struktur (3), beispielsweise einer aktiven Schicht (15) und einer leitenden Rückenschicht (17).

4. Verfahren nach einem der vorhergehenden Ansprüche, umfassend einen Schritt des Überziehens der aktiven Struktur (3) auf der Seite gegenüber dem Tragelement (2) mit einem Überzug (19), der beispielsweise durch eine metallisierte Schicht und/oder eine Polymerschicht gebildet ist.

5. Verfahren nach einem der vorhergehenden Ansprüche, umfassend einen Schritt des Wiederholens des Verfahrens nach einem der Ansprüche 1 bis 4, um eine zweite Platte zu erzeugen, und einen Schritt des Verbindens der beiden Platten (5) miteinander, wobei die betreffenden Platten (5) mit jeweiligen Oberflächen (7) einander zugewandt sind und wobei die aktive Struktur (3) zwischen den beiden Platten (5) eingefügt ist.

6. Verfahren nach Anspruch 5, wobei die beiden Platten (5) jeweils derart geformte Umfangsränder (8) aufweisen, um eine Formkopplung oder eine geometrische Kopplung oder eine mechanische Verbindung zu realisieren.

7. Verfahren nach Anspruch 6, wobei die Umfangsränder (8) der beiden Platten (5) miteinander verbunden und abgedichtet sind, um die aktive Struktur (3) in ihnen abzudichten.

## Revendications

1. Procédé de fabrication d'une cellule photovoltaïque (1), en particulier pour des applications photovoltaïques intégrées dans un bâtiment, comprenant les étapes consistant à :
- mouler une dalle (5) de verre par moulage par pression de verre fondu, formant former directement lors de l'étape de moulage une première face (6) et une seconde face (7), opposée à la première face (6) de la dalle (5), et doter chacune desdites faces opposées (6, 7) de séries respectives de saillies (10) définissant des schémas d'orientation de la lumière pour confiner la lumière incidente sur une première face (6) à l'intérieur de la dalle (5) et éviter ou limiter la sortie de lumière à travers les faces (6, 7) en raison de réflexions totales multiples ; les saillies (10) étant essentiellement des crêtes prismatiques et s'étendant longitudinalement le long d'axes rectilignes respectifs qui sont parallèles les uns aux autres et à un plan central (P) de la dalle (5), et qui sont, lors de l'utilisation, sensiblement horizontaux ; les saillies (10) de chaque face (6, 7) étant agencées parallèlement les unes aux autres selon un espacement déterminé ; chaque saillie (10) présentant une paire de bords latéraux (12) convergeant vers une extrémité libre (13) ou un sommet qui consiste en un bord ; les saillies (10) étant en forme de V et présentant une section transversale sensiblement triangulaire ; la dalle (5) étant une pièce monolithique faite de verre moulé obtenu par moulage sous pression de verre fondu dans un moule présentant deux faces de moulage opposées configurées pour former lesdites faces (6, 7) respectivement, les deux faces (6, 7) étant façonnées selon la forme voulue et dotées desdites saillies (10) directement à l'étape de moulage, un moule présentant deux faces de moulage opposées configurées pour former les faces (6, 7) respectives étant utilisé ; et
- déposer sur ladite seconde face (7) de la dalle (5) opposée à la première face (6), une structure active (3) apte à convertir l'énergie lumineuse en de l'énergie électrique par effet photovoltaïque.

2. Procédé selon la revendication 1, dans lequel la surface de moulage qui forme la face interne (7) est gaufrée ou usinée pour créer une surface microstructurée de la face (7).

3. Procédé selon l'une des revendications précédentes, dans lequel l'étape de dépôt de la structure active (3) comprend les étapes consistant à : appliquer une pluralité d'éléments conducteurs allongés longitudinalement (18) le long de saillies respectives (10) de la seconde face (7) ; déposer une couche conductrice avant (16) de façon à encastrer et enterrer complètement les éléments de contact (18) dans celle-ci, sur le côté opposé à la dalle (5) ; déposer d'autres couches de la structure active (3) à la suite, par exemple, une couche active (15) et une couche conductrice arrière (17).

4. Procédé selon l'une des revendications précédentes, comprenant une étape consistant à recouvrir la structure active (3), sur le côté opposé à l'élément de support (2), d'un revêtement (19), formé par exemple d'une couche métallisée et/ou d'une couche polymère.

5. Procédé selon l'une des revendications précédentes, comprenant une étape consistant à répéter le procédé selon l'une quelconque des revendications 1 à 4, afin de produire une deuxième dalle ; et une étape consistant à accoupler les deux dalles (5) l'une à l'autre, lesdites dalles (5) présentant des faces respectives (7) orientées l'une vers l'autre, la structure active (3) étant interposée entre les deux dalles (5).

6. Procédé selon la revendication 5, dans lequel les deux dalles (5) présentent des bords périphériques respectifs (8) façonnés de façon à réaliser un accouplement par conformation ou géométrique, ou une liaison mécanique.

7. Procédé selon la revendication 6, dans lequel les bords périphériques (8) des deux dalles (5) sont mutuellement reliés et scellés de manière à sceller la structure active (3) à l'intérieur de ceux-ci.
